(19) Europäisches Patentamt
European Patent Office
Office européen des brevets

(11) Veröffentlichungsnummer: **0 029 994**
**A2**

(12) # EUROPÄISCHE PATENTANMELDUNG

(21) Anmeldenummer: 80107344.6

(22) Anmeldetag: 25.11.80

(51) Int. Cl.³: **C 08 G 61/10**
C 08 L 65/00, C 08 K 3/08
H 01 B 1/12, H 01 L 31/02
H 01 H 1/02, C 08 K 5/00

(30) Priorität: 01.12.79 DE 2948454

(43) Veröffentlichungstag der Anmeldung:
10.06.81 Patentblatt 81/23

(84) Benannte Vertragsstaaten:
BE DE FR GB NL

(71) Anmelder: BASF Aktiengesellschaft
Carl-Bosch-Strasse 38
D-6700 Ludwigshafen(DE)

(72) Erfinder: Naarmann, Herbert, Dr.
Haardtblick 15
D-6719 Wattenheim(DE)

(72) Erfinder: Naegele, Dieter, Dr.
Obere Jakobstrasse 8
D-6520 Worms 24(DE)

(72) Erfinder: Penzien, Klaus, Dr.
Bensheimer Ring 18
D-6710 Frankenthal(DE)

(72) Erfinder: Schlag, Johannes, Dr.
Leuschnerstrasse 36
D-6700 Ludwigshafen(DE)

(54) **Verfahren zur Herstellung von elektrisch leitfähigen Polyaromaten und deren Verwendung in der Elektrotechnik und zur antistatischen Ausrüstung von Kunststoffen.**

(57) Die Erfindung betrifft ein Verfahren zur Herstellung von elektrisch leitfähigen Polyaromaten mit elektrischen Leitfähigkeitswerten größer als $10^{-2}$S/cm, wobei Polyaromaten unter Ausschluß von Wasserfeuchtigkeit und von Sauerstoff 0,5 bis 5 Gew.%, bezogen auf den eingesetzten Polyaromaten, an Natrium, Kalium, Rubidium, Cäsium oder deren Amiden, vorzugsweise in Tetrahydrofuran, Dimethoxyglykol, Anthrazen, Naphthalin oder 2-Methylstyrol zugesetzt werden. Die hergestellten leitfähigen Polyaromaten können in der Elektrotechnik zur Herstellung von Sonnenzellen, zur Umwandlung und Fixierung von Strahlung und zur Herstellung elektrischer und magnetischer Schalter oder zur antistatischen Ausrüstung von Kunststoffen verwendet werden.

EP 0 029 994 A2

Croydon Printing Company Ltd.

# Verfahren zur Herstellung von elektrisch leitfähigen Polyaromaten und deren Verwendung in der Elektrotechnik und zur antistatischen Ausrüstung von Kunststoffen

Die Erfindung betrifft ein Verfahren zur Herstellung von elektrisch leitfähigen Polyaromaten mit elektrischen Leitfähigkeitswerten größer als $10^{-2}$ S/cm und deren Verwendung in der Elektroindustrie sowie zur antistatischen Ausrüstung von Kunststoffen.

Es ist bereits bekannt, Polyaromate durch oxidative Kupplung entsprechend der Literatur: "Macromolecular Syntheses Collective", Vol. 1, (1979) Seiten 109 bis 110, Verlag John Wiley & Sons und "Naturwissenschaften" 56 (1969) Seiten 308 bis 313 herzustellen. Außerdem ist die Herstellung von Polyaromaten durch stufenweise Polykondensation nach R. Gehm und W. Kern aus "Makromolekulare Chemie" 7 (1951) Seiten 46-61 bekannt, wobei besonders einheitliche, para-verkettete methylsubstituierte Derivate erhalten werden, die nicht zusätzlich durch ortho- oder meta-verknüpfte Polymere verunreinigt sind.

Der Erfindung lag die Aufgabe zugrunde, die an sich bekannten Polyaromaten durch Zusätze in elektrisch leitfähige Polymere mit elektrischen Leitfähigkeiten größer als $10^{-2}$ S/cm umzuwandeln.

Diese Aufgabe wurde erfindungsgemäß dadurch gelöst, daß man den Polyaromaten unter Ausschluß von Wasserfeuchtigkeit und von Sauerstoff, 0,5 bis 5 Gew.%, bezogen auf den eingesetzten Polyaromaten, an Natrium, Kalium, Rubidium, Cäsium oder deren Amide zugesetzt

werden. Nach bevorzugter Verfahrensweise werden Na, K, Rb, Cs oder deren Amide in Tetrahydrofuran, Dimethoxyglykol, Anthrazen, Naphthalin oder 2-Methylstyrol, jeweils im Molverhältnis 1:1 bis 1:50, vorzugsweise 1:2 bis 1:3, bezogen auf die Hilfsflüssigkeit, zugesetzt.

Unter Polyaromaten werden die an sich bekannten höhermolekulare Produkte verstanden, deren Ketten vollständig aus aneinander gekoppelten, gegebenenfalls Substituenten R tragenden Aromatsystemen gemäß der allgemeinen Formel:

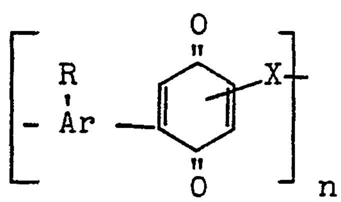

bestehen, und die durch Friedel-Crafts Reaktion unter dehydrierenden Bedingungen sowie andere Verfahren der Dehydrierung bzw. oxidativen Kupplung aus Benzol bzw. substituierten Benzolen mit Benzochinon oder Derivaten erhalten werden. Bevorzugt sind Polyaromaten mit einer linearen Verknüpfung der aromatischen Systeme. Die Polyaromaten weisen ein Molekulargewicht von 200 bis 5000 auf, d.h. n = 1 bis 50. In der obigen Formel kann X = Ar - R sein, Ar ist ein aromatisches System, vorzugsweise Phenylen, R = H oder eine aliphatische, cycloaliphatische, aromatische oder eine funktionelle Gruppe wie z.B. CN oder

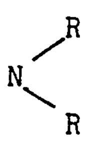 .

Die elektrischen Leitfähigkeitswerte werden in S/cm bei 30°C gemessen, die Messung selbst erfolgt nach der Methode

von F. Beck, "Berichte Bunsengesellschaft, Physikalische Chemie" 68 (1964) Seiten 558 bis 567. Die elektrischen Leitfähigkeitswerte der erfindungsgemäßen leitfähigen Polyaromaten ist größer als $10^{-2}$S/cm. Die Herstellung der Polyaromaten kann nach der eingangs zitierten Literatur sowie nach P.R. Schildneck et.al J. Amer. Chem. Soc. 53 (1931) Seite 2373 erfolgen.

Nach dem erfindungsgemäßen Verfahren wird den Polyaromaten 0,5 bis 5 Gew.%, bezogen auf das eingesetzte Polyphenylen, an Natrium, Kalium, Rubidium, Cäsium oder deren Amide zugesetzt.

Das Einarbeiten der Zusätze erfolgt unter Ausschluß von Feuchtigkeit (Wasser) sowie Sauerstoff (Luft), es wird vorzugsweise unter Argonatmosphäre gearbeitet. Vorzugsweise werden Hilfsflüssigkeiten wie Tetrahydrofuran, Dimethoxyglykol, Anthrazen, Naphthalin oder -Methylstyrol, jeweils im Molverhältnis 1:1 bis 1:50, bezogen auf Alkalimetall oder Amid zur Hilfsflüssigkeit, eingesetzt, die nach dem Einarbeiten bei Temperaturen unter 30°C im Vakuum abgezogen werden. Das obige Molverhältnis ist bevorzugt 1:2 bis 1:3.

Durch die genannten Zusätze können elektrische Leitfähigkeitsanstiege von einigen Größenordnungen erreicht werden. Die Ausgangsleitfähigkeiten der nach der oxydativen Kupplungsmethode hergestellten Polyaromaten betrugen ca. $10^{-12}$ bis $10^{-8}$ S/cm, nach der Zugabe der erfindungsgemäßen Zusätze liegen Leitfähigkeiten von mindestens $10^{-2}$ S/cm vor.

Die erfindungsgemäß hergestellten elektrisch leitfähigen Polyaromaten mit elektrischen Leitfähigkeiten von mindestens $10^{-2}$ S/cm sind zur antistatischen Ausrüstung von Kunststoffen, zur Herstellung von Sonnenzellen, zur Umwandlung und Fixierung von Strahlung sowie zur Herstellung elektrischer und magnetischer Schalter geeignet. Durch die Zusätze der starken Lewis-Basen zum Polyaromaten entstehen sog. n-Leiter.

Die in den folgenden Beispielen genannten Teile sind Gewichtsteile. Die Angabe der Gliederzahl n (Kettenlänge der Polyaromaten) erfolgt durch Endgruppenanalyse über IR-Bestimmung des Verhältnisses der monofunktionellen Endgruppe zur difunktionellen Mittelgruppe.

<u>Beispiele 1 bis 7</u>

10 Teile eines Polyaromaten werden unter Argonatmosphäre und Ausschluß von Feuchtigkeit mit dem jeweiligen Zusatzmittel versetzt, die Messung der elektr. Leitfähigkeit erfolgt nach F. Beck, "Ber. Bunsengesellschaft, Phys. Chem." <u>68</u>, 558 bis 567 (1964).

| Nr. | Polyaromat Typ und Menge | 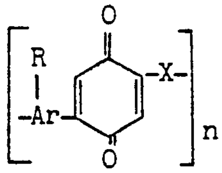 | Dopingmittel Art und Menge | | Leitfähigkeit S/cm 30°C vor d. Dopen, | nach dem Dopen |
|---|---|---|---|---|---|---|
| 1 | 10 Teile, n ca. 3 | (2) | Na | 0,2 | $10^{-5}$ | $4,1 \cdot 10^{-2}$ |
| 2 | 10 Teile, n ca. 5 | (2) | Na | 0,5 | " | $6,3 \cdot 10^{-2}$ |
| 3 | 10 Teile, n ca. 10 | (2) | Na | 1,0 | " | $0,8 \cdot 10^{-1}$ |
| 4 | 10 Teile, n ca. 15 | (2) | Na | 0,2 | $10^{-6}$ | $2,7 \cdot 10^{-1}$ |
| 5 | 10 Teile, n ca. 10 | (2) | Na | 2,0 | $10^{-6}$ | $1,6 \cdot 10^{+2}$ |
| 6 | +10 Teile, n ca. 10 | (2) | Na | 0,2 | $10^{-6}$ | $3,8 \cdot 10^{-2}$ |
| 7 | ++10 Teile, n ca. 20 | (2) | K | 0,2 | $10^{-6}$ | $3,9 \cdot 10^{-2}$ |
| Vgl. | 10 Teile, n = ca.3 (Polyphenylen) | (1) | Na | 0,2 | $10^{-12}$ | $1,8 \cdot 10^{-8}$ |
| 8 | 10 Teile, n = 1 | (2a) | Na | 1,0 | $10^{-5}$ | $2,3 \cdot 10^{-2}$ |

1) bedeutet: nach der Methode R. Gehm et. al. Makromolekulare Chemie 7, (1951) Seiten 46 bis 61

2) bedeutet: nach der Methode (2a) Lit. J. Amer. Chem. Soc. 53 (1931), Seite 2373 und anschließende oxidative Kupplung nach Macromolekulare Synthesis Collective Vol. 1 (1979) Seiten 109 bis 110

In den Beispielen 1 bis 8 bedeutet x = $-\overset{R}{Ar}-$,

In den Beispielen 1 bis 5 und 8 ist $-\overset{R}{Ar}-$ = 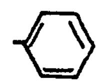

Im Beispiel 6, $-\overset{R}{Ar}-$ = 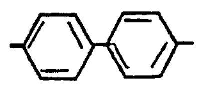

Im Beispiel 7, $-\overset{R}{Ar}-$ = 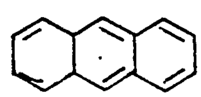

Patentansprüche

1. Verfahren zur Herstellung von elektrisch leitfähigen Polyaromaten mit elektrischen Leitfähigkeitswerten größer als $10^{-2}$S/cm dadurch gekennzeichnet, daß den Polyaromaten unter Ausschluß von Wasserfeuchtigkeit und von Sauerstoff 0,5 bis 5 Gew.%, bezogen auf den eingesetzten Polyaromaten, an Natrium, Kalium, Rubidium, Cäsium oder deren Amiden zugesetzt werden.

2. Verfahren nach Anspruch 1, dadurch gekennzeichnet, daß Na, K, Rb, Cs oder deren Amide in Tetrahydrofuran, Dimethoxyglykol, Anthrazen, Naphthalin oder 2-Methylstyrol, jeweils im Molverhältnis 1:1 bis 1:50, vorzugsweise 1:2 bis 1:3, bezogen auf die Hilfsflüssigkeit, zugesetzt wird.

3. Verwendung der nach Anspruch 1 hergestellten leitfähigen Polyaromaten in der Elektrotechnik zur Herstellung von Sonnenzellen, zur Umwandlung und Fixierung von Strahlung und zur Herstellung elektrischer und magnetischer Schalter.

4. Verwendung der nach Anspruch 1 hergestellten leitfähigen Polyaromaten zur antistatischen Ausrüstung von Kunststoffen.